# EUROPÄISCHE PATENTSCHRIFT

(11) **EP 1 733 421 B1**
(45) Veröffentlichungstag und Bekanntmachung des Hinweises auf die Patenterteilung: **10.08.2016**
(21) Anmeldenummer: 05707734.9
(22) Anmeldetag: 10.03.2005
(51) Int. Cl.: H01L 21/311, H01L 21/3213, H01L 21/768, G03F 7/42, C11D 11/00

(54) **WÄSSRIGE LÖSUNG UND VERWENDUNG DIESER LÖSUNG ZUR ENTFERNUNG VON POST-ETCH RESIDUE VON HALBLEITERSUBSTRATEN**
AQUEOUS SOLUTION AND USE OF SAID SOLUTION FOR REMOVING POST-ETCH RESIDUE OF SEMICONDUCTOR SUBSTRATES
SOLUTION AQUEUSE ET ULTILISATION DE CETTE SOLUTION POUR L'ELIMINATION DE RESIDUS DE POST-GRAVURE DE SUBSTRATS SEMI-CONDUCTEURS

(30) Priorität: 30.03.2004 EP 04007627
(43) Veröffentlichungstag der Anmeldung: 20.12.2006
(73) Patentinhaber: BASF SE, 67056 Ludwigshafen am Rhein (DE)
(72) Erfinder: MELLIES, Raimund, 64807 Dieburg (DE)
(74) Vertreter: BASF IP Association
(86) Internationale Anmeldenummer: PCT/EP2005/002511
(87) Internationale Veröffentlichungsnummer: WO 2005/098920

(56) Entgegenhaltungen:
- EP-A- 0 896 042
- EP-A- 1 024 521
- EP-A- 1 139 401
- WO-A-99/63404
- DE-A1- 4 140 181
- US-A- 6 156 661
- US-A1- 2002 048 953
- US-A1- 2003 143 857
- US-A1- 2004 053 800
- US-B1- 6 199 567
- US-B1- 6 361 407
- US-B1- 6 391 794
- US-B1- 6 417 112
- PATENT ABSTRACTS OF JAPAN Bd. 1999, Nr. 13, 30. November 1999 (1999-11-30) -& JP 11 233405 A (MITSUBISHI GAS CHEM CO INC), 27. August 1999 (1999-08-27)

## Beschreibung

Die vorliegende Erfindung betrifft eine neue Lösung zur Entfernung von Post-Etch-Residues mit verbesserten Eigenschaften und deren Verwendung in der Halbleiterherstellung. Die Erfindung betrifft insbesondere eine wässrige Lösung mit verringerter Ätzrate gegenüber Metallisierungen und gegenüber Oberflächen, die von Post-Etch-Residues und Partikeln während des Herstellungsprozesses von Halbleitern befreit werden müssen.

### Stand der Technik:

Back-end-of-line(BEOL)-Metallisierungen (Leiterbahnen) auf Halbleiterbauteilen bestehen im wesentlichen aus einer aufgesputterten Aluminium/Kupfer-Schicht mit einem Kupferanteil von < 0,5 %. BEOL-Metallisierungen für die
Aluminiumtechnologie werden photolothographisch erzeugt. Als Dielektrikum dient eine SiO₂-Schicht zwischen den einzelnen Metall-Lagen, die in der Senkrechten durch Via-studs (Wolfram oder Aluminium) verbunden sind. Die Strukturen (Leiterbahnen und Vias) werden mittels Reactive-Iron-Etch-Prozess erzeugt. Die BEOL-Metallisierungen werden üblicherweise nach den folgenden Prozessschritten (1) bis (6) erzeugt:

### Prozessablauf zur Erzeugung von Al/Cu-Leiterbahnen:

1. Ganzflächiges Sputtern folgender Schichten auf einer SiO₂-Isolierschicht:
   a. Dünne Ti/TiN Schicht als Diffusionsbarriere
   b. AlCu Metallisierungsschicht
   c. Dünne Ti/TiN Schicht als Anti Reflective Coating (ARC)
2. Aufspinnen des Positiv Fotolacks mit anschließendem Belichten und Entwickeln der Strukturen
3. Ätzen: Reactive Ion Etch (RIE) unter Verwendung halogenhaltiger Ätzgase
4. Verbrennen des Fotolacks im Sauerstoff- bzw. H₂O-Plasma, ggf. mit CF₄-Zusatz
5. DI-Wasser Sprühprozess (Kalt, heiss)
6. Entfernung der PER mittels Nassprozesse.
Während des 3. Schritts entstehen die sogenannten Post-Etch-Residues, bevorzugt an den Seitenwänden der Alu-Leiterbahnen. Sie verändern sich während der Durchführung des 4. und 5. Schritts in ihrer chemischen Zusammensetzung. Die PERs müssen vor der Durchführung der nachfolgenden Prozessschritte im 6. Schritt vollständig entfernt werden.

Als senkrechte elektrische Verbindungen zwischen den Metalllagen dienen Löcher in der SiO₂-Isolierschicht (sogenannte Vias), die mit Wolfram oder Aluminium gefüllt sind. Beim Trockenätzen der Vias entstehen ebenfalls Post-Etch-Residues. Diese haben aber auf Grund der verwendeten Ätzgase eine andere chemische Zusammensetzung als beim AlCu-Ätzen.

Vor der Weiterverarbeitung müssen, wie bereits gesagt, die PER von den Leiterbahnen als auch aus den Vias vollständig entfernt werden.

Die Entfernung der PER erfolgt üblicherweise mittels Nassreinigungsverfahren. Zum Einsatz können hierbei organische Lösungen, die Komplexbildner und Wasser enthalten, kommen. Das derzeit am häufigsten benutzte Produkt EKC^{®} 265 enthält die Komponenten Hydroxylamin, Monoethanolamin, Katechol und Wasser.

Die mit der Entfernung dieser Polymerreste verbundenen Probleme entstehen durch ihre chemische Beständigkeit gegenüber dem AlCu-Basismaterial. Es gilt, diese Polymere zu entfernen, ohne die AlCu-Schicht anzugreifen. Heute werden diese Polymere mittels Nassreinigungsverfahren (Tauch- oder Sprühverfahren) entfernt. Man unterscheidet dabei zwei Mechanismen:
- Die Polymere werden in eine lösliche Form überführt und dann von der Oberfläche durch Auflösen entfernt. Lange Einwirkzeiten bis teilweise ½ Stunde und erhöhte Temperaturen bis ca. 90 °C unterstützen den Auflösungsprozess. Bei diesem Verfahren kommen im wesentlichen organische Lösungsmittel Amine, Ethanolamin, Catechol und Reduktionsmittel wie Hydroxylamin (HDA) zum Einsatz (Patent EP 485 161-A). Diese Verbindungen weisen zwar gute Reinigungswirkungen auf, haben aber den großen Nachteil, giftig zu sein. Hydroxylamin ist außerdem als krebserregend eingestuft. Die Lösungen müssen daher separat entsorgt werden. Bevor die Lösungen mit Wasser abgespült werden können, ist weiterhin ein Zwischenspülschritt mit einem wasserlöslichen Alkohol, meist Isopropanol, erforderlich. Für die Handhabung dieser Lösungen sind entsprechende Schutzmaßnahmen für Gesundheit und Umweltschutz erforderlich.
- Es ist weiterhin möglich, die Polymere durch Behandlung mit wässrigen anorganischen Lösungen zu entfernen. Hierbei handelt es sich um verdünnte Lösungen, die Schwefelsäure, Wasserstoffperoxid, Ammoniumfluorid oder Chromphosphorsäure enthalten können (Patent 0 068 277). Geringe Mengen von Fluoridverbindungen wie z. B. HF beschleunigen den Ätzprozess, so dass diese Mischungen beim Single Wafer Prozess bevorzugt auf Spinetchern eingesetzt werden.
Auch andere Säuren wie Salpetersäure (Patent EP 1 139 401 A1) oder Phosphorsäure bzw. Ammoniumhydrogenphosphat (Patent EP 1 0 63 689 A1) können in diesen Lösungen werden verwendet. Bei all diesen Lösungen wird die AlCu-Metallisierung unter dem Polymer leicht unterätzt, so dass diese in einem ersten Schritt mechanisch entfernt werden (Lift Off). Danach findet eine Auflösung der Polymere statt. Dieses Verfahren erlaubt nur ein relativ kleines Prozessfenster zwischen vollständiger Reinigung und Anätzen der AICu-Metallisierung. Besonders die Reinigung der Vias ist in vielen Fällen unbefriedigend, weil die kurzen Prozesszeiten für eine vollständige Auflösung der Polymere meist nicht ausreichen und das SiO₂ als darunter liegende Schicht von den Lösungen nicht wie beim AlCu unterätzt wird.

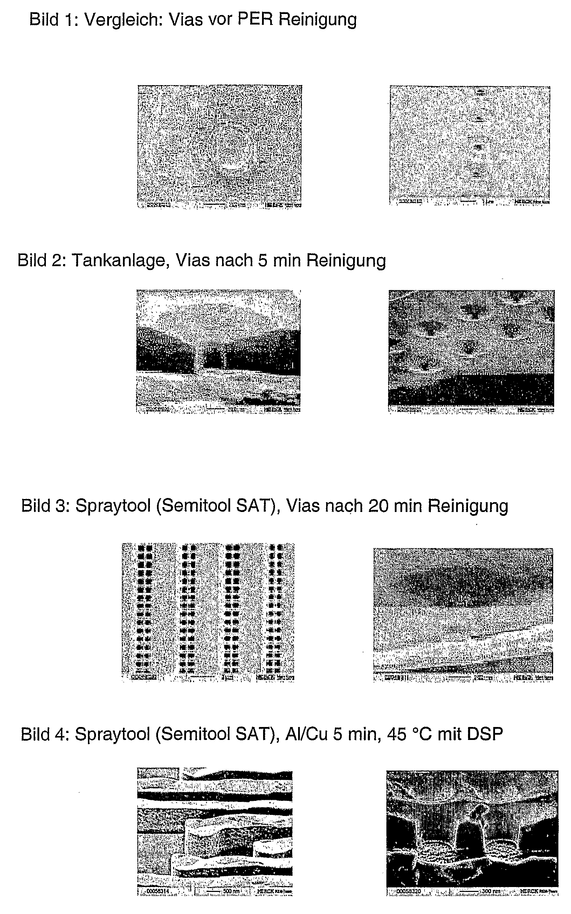

Zur Veranschaulichung zeigt Bild 4 einen Wafer mit AlCu-Leiterzügen und Vias nach dem Reinigen unter ungünstigen Bedingungen mit einer DSP-Lösung (verdünnte Schwefelsäure / Peroxid) bei 45 °C und 5 min. Man sieht deutlich starke Anätzungen der AlCu-Metallisierung sowie einige Polymerreste. Die Vias zeigen außerdem starke Anätzungen der AlCu-Metallisierung im Viaboden.

Die US6391794 B1 offenbart wässrige Lösungen zur Entfernung dielektrischer Anti-Reflex-Schichten (DARC). Die WO99/63404 offenbart Lösungen zur Entfernung von Fotolacken von Halbleitersubstraten enthaltend eine Pyrrolidinonverbindung. Aus JP11233405 A sind wässrige Lösungen und die Verwendung dieser Lösungen zur Entfernung von Post-Etch-Residues von Halbleitersubstraten bekannt.

Aufgabe der vorliegenden Erfindung ist es daher, preiswerte, einfach herstellbare Lösungen zur Entfernung von Polymerresten bzw. Post-Etch-Residues mit verbesserter Reinigungswirkung zur Verfügung zu stellen, welche gegenüber Metallisierungen, Metalloberflächen oder Leiterbahnen verringerte Ätzraten aufweisen. Insbesondere besteht die Aufgabe darin, Reinigungslösungen mit verringerter Ätzrate gegenüber Oberflächen oder Leitungen bestehend aus Al, Cu, Al/Cu, Ti, TiN, SiO₂, W aber auch inert gegenüber Oberflächen bestehend aus Edelstahl zur Verfügung zu stellen.

### Erfindung:

Die Lösung der Aufgabe erfolgt durch Zusammensetzungen, die auf wässrigen Lösungen, gemäß Anspruch 1, welche wenigstens eine Hydroxy-Carbonsäure und in Gegenwart von geeigneten Additiven enthalten und sehr effektiv Vias und Leiterbahnen von "side wall residues" im BEOL-Prozess im Herstellungsprozess von Halbleiterprodukten reinigen.

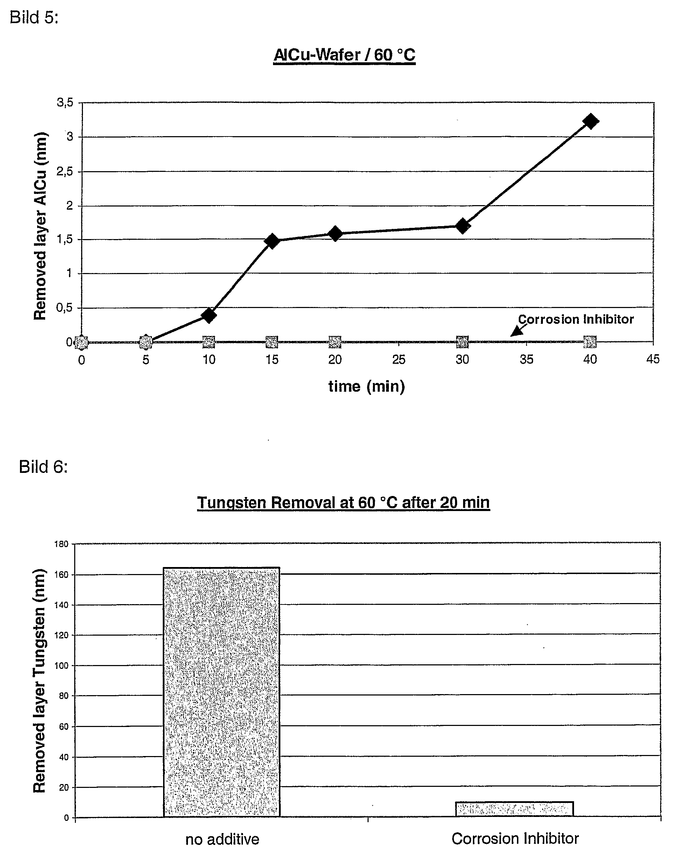

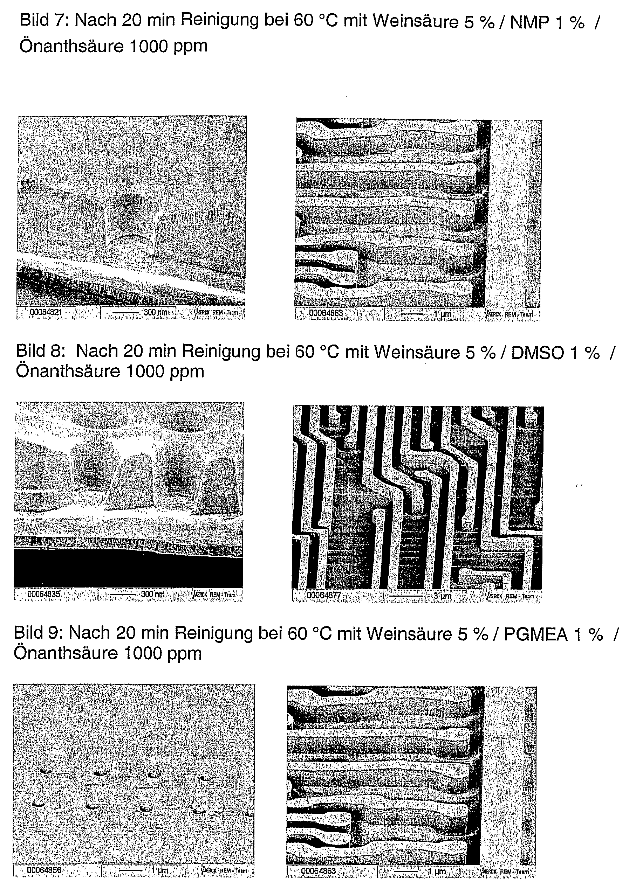

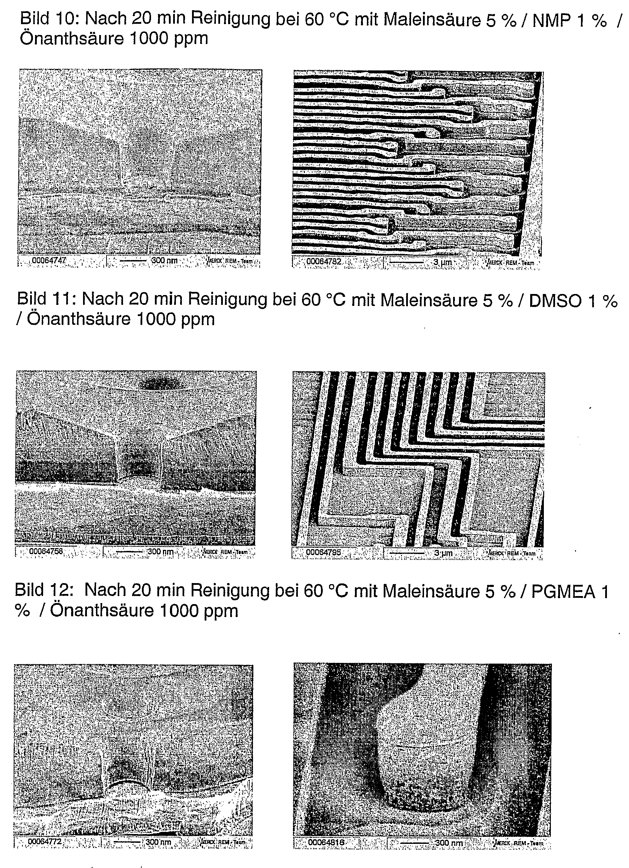

Durch Zusätze, wie Netzmittel und Korrosionsionhibitoren wird eine Anwendung in einem weiten Bereich ermöglicht, bzw. ein breites Prozessfenster bezogen auf die Prozesszeit und die Prozesstemperatur geöffnet. Durch den erfindungsgemäß zugesetzten Korosionsinhibitor werden während der Anwendung insbesondere die Ätzraten von AlCu und Wolfram stark verringert. Die Graphik in Bild 5 zeigt den Abtrag AlCu in nm in Abhängigkeit von der Einwirkzeit der Lösung bei 60 °C. Bereits bei Zusatz von wenigen ppm eines geeigneten Korrosionsinhibitors, kann sich die Entfernung der Metallisierungsschichten durch Ätzen auf 0 nm reduzieren. Der Abtrag von Wolfram kann ohne weiteres durch die Verwendung einer erfindungsgemäßen Reinigungslösung auf diese Weise von 160 nm auf 10 nm bei einer Einwirkzeit von 20 min bei 60 °C reduziert werden wie in Bild 6 gezeigt.
Besonders gute Ergebnisse wurden mit Zusammensetzungen erzielt, worin die Zusätze in Mengen enthalten sind, die im folgenden als besonders bevorzugt angegeben sind.
Das erzielbare Ergebnis ist im einzelnen abhängig von den Bedingungen der vorhergehenden Prozessschritte und der daraus resultierenden Zusammensetzung der gebildeten Polymere. Für den Fachmann ist es jedoch ohne weiteres möglich, das optimale Mengenverhältnis der Komponenten der Zusammensetzung durch wenige Versuche im Rahmen der gegebenen Mengenbereiche einzustellen.

Prozesszeit und Temperatur können bei Verwendung der erfindungsgemäßen Zusammensetzungen variabel den Erfordernissen des Reinigungsprozesses angepasst werden, ohne dass die Metallisierungen oder Oberflächen angegriffen werden.

Bei der Anwendung von üblicherweise eingesetzten wässrigen, anorganischen Lösungen wie beispielsweise von DSP bzw. DSP+, wobei ein leichtes Unterätzen der Alu-/Kupfer-Metallisierung bewusst zur Entfernung der PER ausgenutzt wird (Lift-off), besteht die Gefahr, dass durch ein Überätzen die Metallstrukturen angegriffen werden. Dieses kann soweit gehen, dass Lochkorrosion auftritt. Aus diesem Grund müssen bei diesen bekannten Zusammensetzungen
a) die Einwirkzeiten sehr kurz gehalten werden (ca. 1 Minute, maximal wenige Minuten) und
b) der Reinigungsprozess benötigt aber ein Minimum an Einwirkzeit, um die PER vollständig zu entfernen bzw. aufzulösen.
Dieses enge Prozessfenster zwischen Anätzung und vollständiger Reinigungswirkung wird oft nur erreicht, wenn der vorausgegangene Reactive-Iron-Etch-Prozess entsprechend optimiert worden ist. Besondere Schwierigkeiten gibt es bei der Via-Reinigung, da hier ein Unterätzen des Dielektrikums SiO₂ nicht möglich ist.

Durch Versuche wurde überraschenderweise nun gefunden, dass diese Nachteile der üblicherweise für diesen Zweck verwendeten Zusammensetzungen durch die Verwendung einer wässrigen Formulierung vermieden werden können, welche mindestens eine Hydroxycarbonsäure in einer Menge von 0,1 bis 30 % bezogen auf das Gesamtgewicht, Wasserstoffperoxid in einer Menge von 0,1 bis 10 % bezogen auf das Gesamtgewicht und Imidazolinverbindungen zur Vermeidung von Korrosion enthält.

Besonders vorteilhaft haben sich die verbesserten Eigenschaften der erfindungsgemäßen Lösungen bei der Entfernung sogenannter "Post-Etch-Residues" erwiesen. Letztere sind Reaktionsprodukte, die während des Trockenätzens aus den Bestandteilen des Fotolacks, der Ätzgase und dem geätzten Material entstehen. Diese Reaktionsprodukte lagern sich bevorzugt an den Seitenwänden der metallisierten Flächen, insbesondere der Al/Cu-Leiterbahnen und an den Innenseiten der SiO₂-Vias an wie in Bild 1 zu erkennen ist. Ein besonderer Vorteil der erfindungsgemäßen Lösungen besteht in der besonders effektiven Reinigung der Vias und der Metall-Leiterbahnen ohne dass die darunter liegende Al/Cu-Metallisierung angegriffen wird. Die Lösungen sind umweltverträglich, ungiftig und können problemlos neutralisiert und entsorgt werden. Die Zusammensetzungen haben einen niedrigen Dampfdruck, stellen keine Explosionsgefahr dar und erfordern während des Reinigungsvorgangs keine Absaugung.
Darüber hinaus lassen sich die erfindungsgemäßen Zusammensetzungen entsprechend der Qualitätsanforderungen in der Halbleiterindustrie in hoher Reinheit aus üblicherweise in der Halbleiterindustrie verwendeten und im Handel erhältlichen hochreinen Substanzen herstellen.

Besonders positive Ergebnisse haben sich durch die Verwendung der neuen Lösungen bei der Via-Reinigung ergeben. Bereits nach einer Prozesszeit von 5 Minuten bei 60 °C in einem Spray- und Tankprozessor ist eine vollständige Reinigung der Vias erfolgt, wie in Bild 2 gezeigt werden kann. Ein Zusatz von geeigneten Tensiden zu der Lösung sorgt für eine optimale Benetzung der Waferoberfläche und fördert die Reinigungswirkung. Optimale Ergebnisse wurden mit Prozesszeiten zwischen 5 und 20 min, bei einer Temperatur im bereich von 45 bis 75 °C, insbesondere im Bereich von 50 bis 70 °C, ganz besonders bevorzugt im Bereich von 55 bis 65 °C, erreicht, wie in den Bildern 2 und 3 gezeigt werden kann.

Durch die vorliegende Erfindung werden Zusammensetzungen zur Verfügung gestellt, die in der Anwendung zu wesentlichen Verbesserungen führen. Diese bestehen beispielsweise in einer äußerst geringe Ätzrate auf Metallisierungen, wie beispielsweise auf einer AI-/Cu-Metallisierung oder solchen aus Al, Cu, Ti, W oder gegenüber TiN- oder SiO₂-Schichten. Hierdurch werden Einwirkzeiten von bis zu 30 min bei einer Temperatur von 50 bis 70 °C, vorzugsweise 60 °C, ermöglicht. In Bild 4 wird ein entsprechendes Reinigungsergebnis gezeigt. Die erfindungsgemäße Lösung kann sowohl auf Spraytools und Spinprozessoren als auch auf Tankanlagen erfolgreich eingesetzt werden. Die gereinigten Wafer können direkt mit Reinstwasser gespült und anschließend mit Stickstoff getrocknet werden. Ein Zwischenspülschritt wie bei den organischen Lösungen (z. B. Isopropanol) entfällt.

Wie bereits oben erwähnt, kann dieses verbesserte Ergebnis anhand de REM-Bilder 1 bis 3 sehr gut veranschaulicht werden. Erfindungsgemäß kann durch Zusatz von Additiven, wie beispielsweise von Tensid und NMP, die Reinigungswirkung deutlich verbessert werden. Der eingesetzte Korrosionsinhibitor reduziert dabei zum einen die Ätzrate auf Wolfram zum anderen aber auch von Al/Cu, wie aus den Bildern 4 und 5 zu entnehmen ist.

Geeignete, erfindungsgemäße Lösungen für die Entfernung der PER sind wässrige Lösungen die mindestens eine organische Säure ausgewählt aus der Gruppe der Hydroxycarbonsäuren in einer Menge von 0,1 bis 30 % bezogen auf das Gesamtgewicht enthalten. Geeignete Hydroxycarbonsäuren sind Glycolsäure, Milchsäure, Hydroxybuttersäure, Glycerolsäure, Äpfelsäure, Weinsäure, Citronensäure. Außer mindestens einer organischen Säure ist in der erfindungsgemäßen Zusammensetzung Wasserstoffperoxid in einer Menge von 0,1 bis 10 % bezogen auf das Gesamtgewicht enthalten.

Zusätzlich können in den erfindungsgemäßen Lösungen verschiedenste Additive zur Verbesserung der Reinigungswirkung und zum Schutz der Oberflächen, welche nicht angegriffen werden sollen, enthalten sein. Erfindungsgemäß werden daher Imidazolinverbindungen als Korrosionsinhibitoren zugesetzt zur Behandlung von Waferoberflächen, die beispielsweise Metallisierungen aus Wolfram und Aluminium besitzen. Geeignete Imidazolinverbindungen sind Benzimidazole (alkylsubstituierte Imidazoline or 1,2-Dialkylimidazoline), Aminobenzimidazole und 2-Alkylbenzimidazole. Besonders gute Reinigungsergebnisse werden mit Lösungen erzielt, die Ölsäurehydroxyethylimidazolin als Korrosionsinhibitor enthalten.

Zur Unterstützung der Reinigungswirkung und zum Schutzes der Waferoberflächen ist es vorteilhaft, wenn der Lösung ein aprotisches polares Lösungsmittel zugesetzt wird. Geeignete aprotische polare Lösungsmittel für diesen Zweck sind N-Methylpyrrolidon (NMP), Ethylenglykol, Propylenglykol, Dimethylsulfoxid (DMSO), (1-Methoxy-2-propyl)-acetat (PGMEA). Diese organischen Lösungsmittel können in der Lösung einzeln oder im Gemisch enthalten sein.

Weiterhin hat es sich als vorteilhaft erwiesen, wenn in der Reinigungslösung zusätzlich oberflächenaktive Substanzen enthalten sind. Als geeignete oberflächenaktive Substanzen haben sich anionische Tenside erwiesen. Besonders geeignete Tenside sind solche ausgewählt aus der Gruppe der aliphatischen Carbonsäuren und/oder aus der Gruppe der Alkylbenzolsulfonsäuren. Geeignete aliphatische Carbonsäuren sind beispielsweise Heptansäure und Octansäure. Als Alkylbenzolsulfonsäuren kann u. a. Dodecylbenzolsulfonsäure eingesetzt werden.

Anionische Tenside können gemeinsam mit nichtionischen Tensid eingesetzt oder durch diese ersetzt werden. Als nichtionische Tenside können solche aus der Gruppe der Alkyloxalkylate und/oder der Alkylphenoloxethylate eingesetzt werden. Für diesen Zweck geeignete Alkyloxalkylate sind beispielsweise Fettalkoholalkoxylate. Als Alkylphenoloxethylate kann u. a. Octylphenoloxethylat zugesetzt werden. Weiterhin sind Sorbitanverbindungen, wie Polyoxyethylen -Sorbitan-Fettsäureester, als Tenside in den erfindungsgemäßen Lösungen geeignet. Hierzu zählen Tenside wie z. B. im Handel unter dem Namen Tween^{®} erhältliche Produkte.

Die durchgeführten Versuche haben gezeigt, dass die erfindungsgemäßen Lösungen bei Temperaturen im Bereich von 40 bis 70 °C wesentlich verbesserte Reinigungsergebnisse zeigen als bisher bekannte Reinigungslösungen.

Überraschenderweise ist es mit den erfindungsgemäßen Lösungen möglich, in einer Reinigungszeit (Strippzeit) von einer Minute bis 60 Minuten wesentlich verbesserte Reinigungsergebnisse zu erzielen als mit bisher bekannten Zusammensetzungen. Vorteilhafter Weise können während des Reinigungsvorgangs die PER vollständig entfernt werden, wobei jedoch weder die metallisierten Leiterbahnen noch andere Oberflächen, wie z. B. aus TiN, oder SiO₂, erkennbar angegriffen werden.

Erfindungsgemäße Reinigungslösungen 5 bis 8 mit verbesserten Reinigungswirkungen können daher Zusammensetzungen aufweisen, wie in der folgen Tabelle dargestellt:

**Tabelle 1:**

| | 1 | 2 | 3 | 4 | 5 | 6 | 7 | 8 |
|---|---|---|---|---|---|---|---|---|
| Organische Säure | x | x | x | X | x | x | x | x |
| Oxidationsmittel | x | x | x | X | x | x | x | x |
| Lösungsmittel | | x | | X | | | x | x |
| Tensid | | | x | X | | x | x | |
| Korrosionsinhibitor | | | | | x | x | x | x |

Die erfindungsgemäßen wässrigen Reinigungslösungen können die einzelnen Komponenten wie folgt enthalten:
- organischen Säure aus der Gruppe der Hydroxycarbonsäuren in einer Menge von 0,1 bis 30%
- Wasserstoffperoxid in einer Menge von 0,1 bis 10 %
- Korrosionsinhibitoren aus der Gruppe der Imidazolinverbindungen für Wolfram und Aluminium in einer Menge von 1 ppm bis 1 %
- aprotisches polares Lösungsmittel in einer Menge von 0,1 bis 10 %
- anionisches Tensid aus der Gruppe der aliphatischen Carbonsäuren und der Alkylbenzolsulfonsäuren in einer Menge von 1 ppm bis 1 %
   und / oder
- nichtionisches Tensid aus der Gruppe der Alkyloxalkylate, Alkylphenoloxethylate und Sorbitanverbindungen in einer Menge von 1 ppm bis 1 %

In geeigneten Reinigungslösungen mit verbesserten Eigenschaften können die Komponenten daher in den folgenden Mengen enthalten sein:

| | |
|---|---|
| • Hydroxycarbonsäure | 0,1 bis 30 % |
| • Wasserstoffperoxid | 0,1 bis 30 % |
| • N-Methyl-pyrrolidon und/oder DMSO | 0,1 bis 10 % |
| • Korrosionsinhibitor | 1 ppm bis 1% |
| • Anionisches oder nichtionisches Tensid | 1 ppm bis 1 % |

Besonders gute Reinigungsergebnisse können erzielt werden mit Zusammensetzungen, die aus folgenden Komponenten bestehen:

| | |
|---|---|
| • Hydroxycarbonsäure (Citronensäure, Weinsäure) | 5 (+/- 2) % |
| • Wasserstoffperoxid | 2 (+/- 0,5) % |
| • Lösungsmittel (NMP, DMSO, PGMEA) | 1 (+/- 0,5) % |
| • Korrosionsinhibitor (Oleic hydroxyethyl imidazoline) | 100 bis 1000 ppm |
| • Netzmittel | 100 bis 1000 ppm |

(Önanthsäure, Triton X100, Tween 20, Dodecylbenzolsulfonsäure, Plurafac 120)

Besonders geeignet sind Lösungen, in denen beispielsweise die genannten Komponenten in den folgenden Mengen enthalten sind:

| | |
|---|---|
| • Citronensäure | 0,1 bis 30 % |
| • Wasserstoffperoxid | 0,1 bis 10 % |
| • N-Methyl-pyrrolidon NMP | 0,1 bis 10 % |
| • Korrosionsinhibitor | 1 bis 1000 ppm |
| • Netzmittel | 1 bis 1000 ppm |

Ganz besonders günstige Eigenschaften zeigen in diesem Zusammenhang Zusammensetzungen, in denen die folgenden Komponenten in den gegebenen Mengen enthalten sind:

| | |
|---|---|
| • Citronensäure | 5 (+/- 2) % |
| • Wasserstoffperoxid | 2 (+/- 1) % |
| • N-Methyl-pyrrolidon NMP | 1 (+/- 0,5 %) |
| • Korrosionsinhibitor (Oleic hydroxyethyl imidazoline) | 50 bis 1000 ppm |
| • Netzmittel | 100 bis 1000 ppm |

Besonders bei der schwierigen Via-Reinigung haben sich die oben genannten Mischungen als sehr effektiv erwiesen, siehe Bild 2.

Durch die Behandlung der Waferoberflächen mit den erfindungsgemäßen wässrigen Lösungen werden nicht nur die PER von den Oberflächen entfernt sondern die Oberflächen werden gleichzeitig auch von anhaftenden störenden Partikeln befreit. Dieses hat den Vorteil, dass im Anschluss an die Entfernung der PER aufwendige Reinigungsschritte entfallen können.

Vorteilhafter Weise handelt es sich bei den erfindungsgemäßen Zusammensetzungen um stabile Zusammensetzungen, die auch nach längerer Lagerzeit keine Zersetzung zeigen. Wie oben bereits erwähnt, sind die Zusammensetzung umweltverträglich und können einfach entsorgt werden. Sie sind auf Sprühanlagen ebenso einsetzbar wie in Tankprozessoren. Falls erwünscht können sie auch recycelt werden.

Bei allen Prozentangaben der vorliegenden Beschreibung handelt es sich um Gewichtsprozent, die sich auf die Gesamtmenge der Lösungen beziehen. Es versteht sich hierbei von selbst, dass sich in einer Zusammensetzung die Menge der zugesetzten Komponenten zu 100% aufaddieren.

### Beispiele

Zum besseren Verständnis und zur Verdeutlichung der Erfindung werden im folgenden Beispiele auch in Form von Abbildungen, die das Reinigungsergebnis zeigen, wiedergegeben.

Die in den Beispielen gegebenen Temperaturen gelten immer in °C.

### Beispiel 1 (nicht erfindungsgemäß)

### Referenz (post ash residue) vor Reinigung

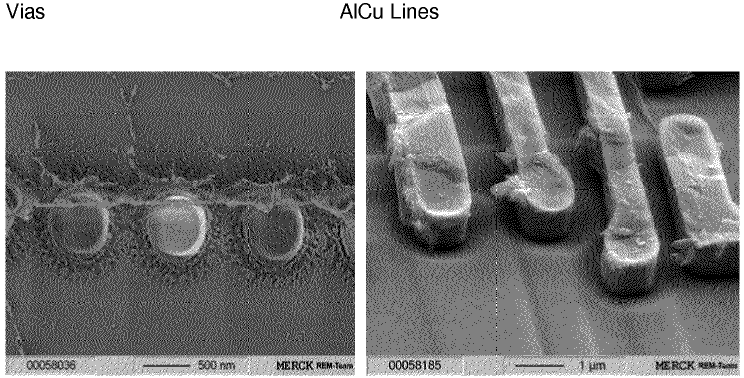

Die Reinigung erfolgt mit einer wässrigen Reinigungslösung, worin folgende Komponenten enthalten sind:

| | |
|---|---|
| • Citronensäure | 5 % |
| • Wasserstoffperoxid | 2 % |
| • NMP | 1 % |
| • Tween 20 | 1000 ppm |

### Prozessparameter auf Semitool SAT Spraytool:

| **Step** | **Name** | **Zeit** | **RPM** | **Temp.** | | **DRAIN** |
|---|---|---|---|---|---|---|
| 1 | Polymer-Removal | 5 min | 50 U/min | 60 °C | | Tank |
| 2 | Purge | 10 sek | 50 U/min | | N2 | Tank |
| 3 | DI-Rinse1 | 5 min | 50 U/min | RT | H2O | Drain |
| 4 | DI-Rinse2 | 2 min | 300 U/min | RT | | |
| 4 | Purge | 10 sek | 300 U/min | | N2 | Drain |
| 5 | Dry-1 | 2 min | 750 U/min | hot | N2 | |
| 6 | Dry-2 | 8 min | 300 U/min | hot | N2 | |

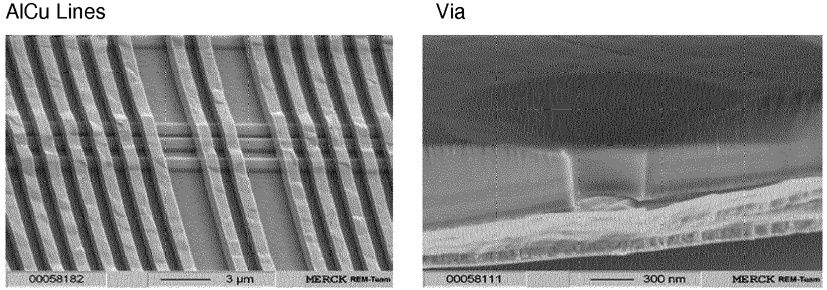

### Beispiel 2 (erfindungsgemäß)

Die Reinigung erfolgt mit einer wässrigen Reinigungslösung, worin folgende Komponenten enthalten sind:

| | |
|---|---|
| • Citronensäure | 5 % |
| • Wasserstoffperoxid | 2 % |
| • Oleic hydroxyethyl imidazoline | 1000 ppm |

### Prozessparameter auf Arias Wet Bench

| **STEP** | **NAME** | **ZEIT** | **Temp** | | **Drain** |
|---|---|---|---|---|---|
| 1 | Polymer-Removal | 20 min | 60 °C | | |
| 2 | DI-Rinse1 | 10 min | RT | H2O | |
| 3 | Dry-1 | 2 min | hot | N2 | |
| 4 | Dry-2 | 8 min | hot | N2 | |

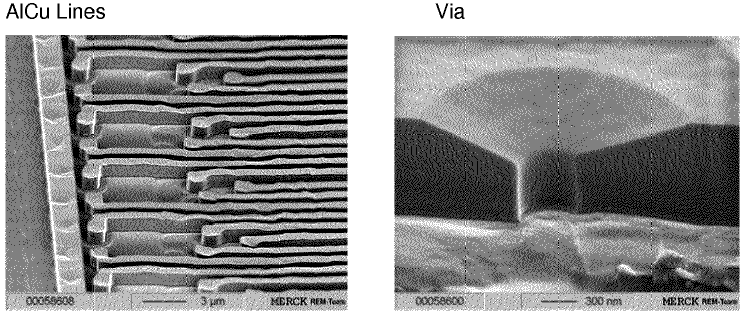

### Beispiel 3 (nicht erfindungsgemäß)

Vergleich mit einem kommerziell erhältlichen organischen Polymer Remover
1. Polymer Remover (enthält Hydroxylamin, Catechol, Monoethanolamin) 75 °C, 20 min (Becherglas)
2. IPA RT, 3 min
3. DI-Wasser RT, 5 min
4. N2 Trockenblasen 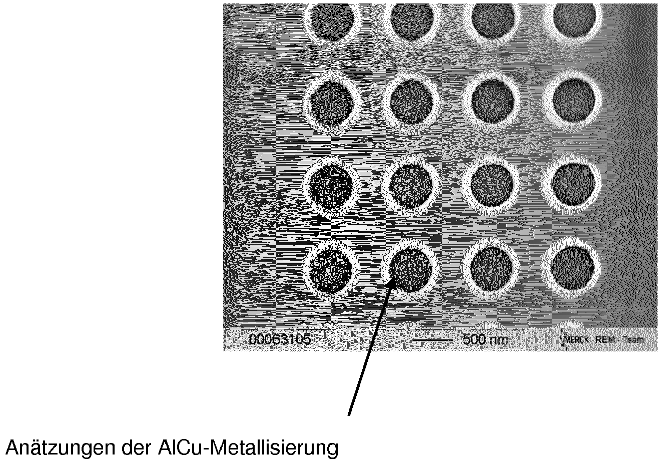
   1. Citronensäure 5 % / Peroxid 2 % / NMP 1 % / Tween 20 1000 ppm 60 °C, 20 min (Becherglas)
   2. DI-Wasser 10 min
   3. N2 Trockenblasen

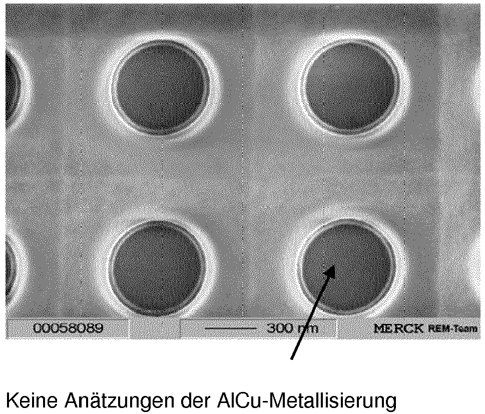

### Bilderläuterungen:

Bild 5: Darstellung des Massenabtrags einer gesputterten Al/Cu-Schicht in Abhänigkeit der Einwirkzeit. Die verwendete Lösung bestand aus einer wäßrigen Lösung von 5% Citronensäure, 2% Peroxid, 1% NMP. Die dunkle Kurve zeigt den Abtrag ohne Korrosionsinhibitor. Die helle Linie zeigt den Abtrag bei Zusatz eines Korrosionsinhibitors.
Bild 6: Darstellung des Massenabtrags einer CVO -abgeschiedenen Wolframschicht in Abhängigkeit der Einwirkzeit. Die verwendete Lösung (siehe Bild 5).

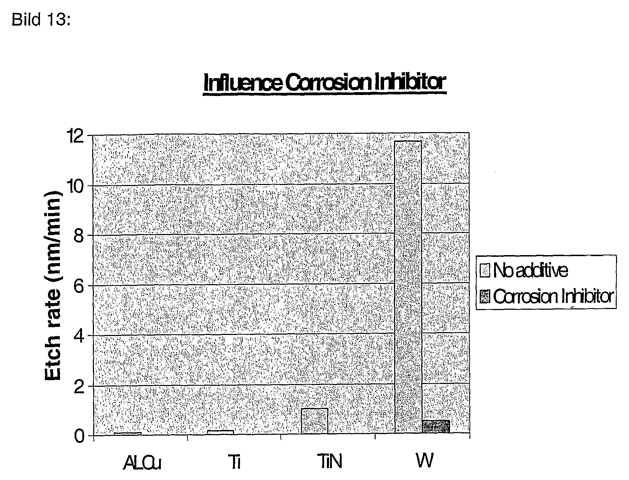

Bild 13: Darstellung der Ätzrate (Abtrag/Zeit) verschiedener Beschichtung, mit/ohne Zusatz eines Korrosionsinhibitors in der Lösung (siehe Bild 5).

## Patentansprüche

1. Wässrige Lösung zur Post-Etch-Residue-Entfernung in der Halbleiterherstellung mit verringerter Ätzrate gegenüber Metallisierungen, enthaltend mindestens eine Hydroxycarbonsäure in einer Menge von 0,1 bis 30 % bezogen auf das Gesamtgewicht, Wasserstoffperoxid in einer Menge von 0,1 bis 10 % bezogen auf das Gesamtgewicht, mindestens einen Korrosionsinhibitor ausgewählt aus der Gruppe der Imidazolinverbindungen.

2. Wässrige Lösung gemäß Anspruch 1, wobei die Korrosionsinhibitoren ausgewählt sind aus der Gruppe Benzimidazol, Aminobenzimidazol und 2-Alkylbenzimidazoleinschließlich alkylsubstituierter Imidazoline und 1,2-Dialkylimidazoline und Ölsäurehydroxyethylimidazolin.

3. Wässrige Lösung gemäß Anspruch 1 oder 2, enthaltend mindestens ein aprotisches polares Lösungsmittel.

4. Wässrige Lösung gemäß Anspruch 3, wobei das mindestens eine aprotische polare Lösungsmittel ausgewählt ist aus der Gruppe N-Methylpyrrolidon (NMP), Ethylenglykol, Propylenglykol, Dimethylsulfoxid (DMSO) und (1Methoxy-2-propyl)-acetat (PGMEA).

5. Wässrige Lösung gemäß einem der Ansprüche 1 bis 4, enthaltend mindestens ein anionisches Tensid und/oder ein nicht-ionisches Tensid.

6. Wässrige Lösung gemäß Anspruch 5, wobei das mindestens eine anionisches Tensid ausgewählt ist aus der Gruppe der aliphatischen Carbonsäuren und Alkylbenzolsulfonsäuren und/oder das mindestens eine nicht-ionische Tensid ausgewählt ist aus der Gruppe der Alkoxalkylate und der Alkylphenoloxethylate.

7. Wässrige Lösung gemäß einem der Ansprüche 5 oder 6, wobei das mindestens eine anionische Tensid ausgewählt ist aus der Gruppe Heptansäure, Octansäure und Dodecylbenzolsulfonsäure und/oder das mindestens eine nicht-ionische Tensid ausgewählt ist aus der Gruppe Fettalkoholalkoxylate, Octylphenoloxethylate, Polyoxyethylen-Sorbitan-Fettsäureester.

8. Wässrige Lösung gemäß einem der Ansprüche 1 bis 7, wobei die Hydroxycarbonsäure ausgewählt ist aus der Gruppe Glycolsäure, Milchsäure, Hydroxybuttersäure, Glycerolsäure, Äpfelsäure, Weinsäure und Citronensäure.

9. Wässrige Lösung gemäß der Ansprüche 1 bis 8, enthaltend den mindestens einen Korrosionsinhibitor in einer Menge von 1 ppm bis 1 % bezogen auf das Gesamtgewicht.

10. Wässrige Lösung gemäß einem der Ansprüche 3 oder 4, enthaltend das mindestens eine aprotische polare Lösungsmittel in einer Menge von 0,1 bis 10 % bezogen auf das Gesamtgewicht.

11. Wässrige Lösung gemäß einem der Ansprüche 1 bis 10, enthaltend das mindestens eine anionische Tensid in einer Menge von 1 ppm bis 1 % bezogen auf das Gesamtgewicht und/oder mindestens ein das mindestens eine nicht-ionische Tensid in einer Menge von 1 ppm bis 1 % bezogen auf das Gesamtgewicht.

12. Wässrige Lösung gemäß der Ansprüche 1 bis 11, wobei die Hydroxycarbonsäure Citronensäure und das aprotische polare Lösungsmittel N-Methyl-pyrrolidon (NMP) ist.

13. Wässrige Lösung gemäß Anspruch 12, wobei N-Methyl-pyrrolidon in einer Menge von 0,1 bis10% enthalten ist.

14. Verwendung einer wässrigen Lösung gemäß der Ansprüche 1 bis 13 zur Post-Etch-Residue-Entfernung in der Halbleiterherstellung.

15. Verfahren zur Entfernung von Post-Etch-Residues von Halbleitersubstraten nach dem Trockenätzen bei dem das Hableitersubstrat einem Ätzschritt unterworfen wird und anschließend mit einer Lösung gemäß einem der Ansprüche 1 bis 13 behandelt wird.

## Claims

1. Aqueous solution for post-etch residue removal in semiconductor production having a reduced etching rate on metallisations, comprising at least one hydroxycarboxylic acid in an amount of from 0.1 to 30%, based on the total weight, hydrogen peroxide in an amount of from 0.1 to 10%, based on the total weight, at least one corrosion inhibitor selected from the group consisting of imidazoline compounds.

2. Aqueous solution according to Claim 1, wherein the corrosion inhibitors are selected from the group consisting of benzimidazole, aminobenzimidazole and 2-alkylbenzimidazole, including alkyl-substituted imidazolines and 1,2-dialkylimidazolines and oleic hydroxyethyl imidazoline.

3. Aqueous solution according to Claim 1 or 2, comprising at least one aprotic polar solvent.

4. Aqueous solution according to Claim 3, wherein the at least one aprotic polar solvent is selected from the group consisting of N-methylpyrrolidone (NMP), ethylene glycol, propylene glycol, dimethyl sulfoxide (DMSO) and 1-methoxy-2-propyl acetate (PGMEA).

5. Aqueous solution according to one of Claims 1 to 4, comprising at least one anionic surfactant and/or nonionic surfactant.

6. Aqueous solution according to Claim 5, wherein the at least one anionic surfactant is selected from the group consisting of aliphatic carboxylic acids and alkylbenzenesulfonic acids and/or the at least one nonionic surfactant is selected from the group consisting of alkyl oxalkylates and alkylphenol oxethylates.

7. Aqueous solution according to one of Claims 5 and 6, wherein the at least one anionic surfactant is selected from the group consisting of heptanoic acid, octanoic acid and dodecylbenzenesulfonic acid and/or the at least one nonionic surfactant is selected from the group consisting of fatty alcohol alkoxylates, octylphenol oxethylates and polyoxyethylene sorbitan fatty acid esters.

8. Aqueous solution according to one of Claims 1 to 7, wherein the hydroxycarboxylic acid is selected from the group consisting of glycolic acid, lactic acid, hydroxybutyric acid, glyceric acid, malic acid, tartaric acid and citric acid.

9. Aqueous solution according to Claims 1 to 8, comprising the at least one corrosion inhibitor in an amount of from 1 ppm to 1%, based on the total weight.

10. Aqueous solution according to one of Claims 3 and 4, comprising the at least one aprotic polar solvent in an amount of from 0.1 to 10%, based on the total weight.

11. Aqueous solution according to one of Claims 1 to 10, comprising the at least one anionic surfactant in an amount of from 1 ppm to 1%, based on the total weight, and/or the at least one nonionic surfactant in an amount of from 1 ppm to 1%, based on the total weight.

12. Aqueous solution according to Claims 1 to 11, wherein the hydroxycarboxylic acid is citric acid and the aprotic polar solvent is N-methylpyrrolidone (NMP).

13. Aqueous solution according to Claim 12, wherein N-methylpyrrolidone is present in an amount of from 0.1 to 10%.

14. Use of an aqueous solution according to Claims 1 to 13 for post-etch residue removal in semiconductor production.

15. Process for removing post-etch residues of semiconductor substrates after dry etching, in which process the semiconductor substrate is subjected to an etching step and subsequently is treated with a solution according to one of Claims 1 to 13.

## Revendications

1. Solution aqueuse pour l'élimination de résidus post-gravure dans la fabrication de semi-conducteurs, présentant une vitesse de gravure réduite par rapport aux métallisations, contenant au moins un acide hydroxycarboxylique en une quantité de 0,1 à 30% par rapport au poids total, du peroxyde d'hydrogène en une quantité de 0,1 à 10% par rapport au poids total, au moins un inhibiteur de corrosion choisi dans le groupe des composés d'imidazoline.

2. Solution aqueuse selon la revendication 1, les inhibiteurs de corrosion étant choisis dans le groupe constitué par les benzimidazoles, l'aminobenzimidazole et les 2-alkyl-benzimidazoles, y compris les imidazolines substituées par alkyle et la 1,2-dialkylimidazoline, et l'ester hydroxyéthylimidazolinique de l'acide oléique.

3. Solution aqueuse selon la revendication 1 ou 2, contenant au moins un solvant polaire aprotique.

4. Solution aqueuse selon la revendication 3, ledit au moins un solvant polaire aprotique étant choisi dans le groupe constitué par la N-méthylpyrrolidone (NMP), l'éthylèneglycol, le propylèneglycol, le diméthylsulfoxyde (DMSO) et l'acétate de 1-méthoxy-2-propyle (PGMEA).

5. Solution aqueuse selon l'une quelconque des revendications 1 à 4, contenant au moins un agent tensioactif anionique et/ou un agent tensioactif non ionique.

6. Solution aqueuse selon la revendication 5, ledit au moins un agent tensioactif anionique étant choisi dans le groupe constitué par les acides carboxyliques aliphatiques et les acides alkylbenzènesulfoniques et/ou ledit au moins un agent tensioactif non ionique étant choisi dans le groupe formé par les alcoxalkylates et les phénoloxéthylates d'alkyle.

7. Solution aqueuse selon l'une quelconque des revendications 5 ou 6, ledit au moins un agent tensioactif anionique étant choisi dans le groupe formé par l'acide heptanoïque, l'acide octanoïque et l'acide dodécylbenzènesulfonique et/ou ledit au moins un agent tensioactif non ionique étant choisi dans le groupe formé par les alcoxylates d'alcools gras, les phénoloxéthylates d'octyle, les esters d'acides gras de polyoxyéthylène-sorbitane.

8. Solution aqueuse selon l'une quelconque des revendications 1 à 7, l'acide hydroxycarboxylique étant choisi dans le groupe formé par l'acide glycolique, l'acide lactique, l'acide hydroxybutyrique, l'acide glycérique, l'acide malique, l'acide tartrique et l'acide citrique.

9. Solution aqueuse selon les revendications 1 à 8, contenant ledit au moins un inhibiteur de corrosion en une quantité de 1 ppm à 1% par rapport au poids total.

10. Solution aqueuse selon l'une quelconque des revendications 3 ou 4, contenant ledit au moins un solvant polaire aprotique en une quantité de 0,1 à 10% par rapport au poids total.

11. Solution aqueuse selon l'une quelconque des revendications 1 à 10, contenant ledit au moins un agent tensioactif anionique en une quantité de 1 ppm à 1% par rapport au poids total et/ou ledit au moins un agent tensioactif non ionique en une quantité de 1 ppm à 1% par rapport au poids total.

12. Solution aqueuse selon les revendications 1 à 11, l'acide hydroxycarboxylique étant l'acide citrique et le solvant polaire aprotique étant la N-méthylpyrrolidone (NMP).

13. Solution aqueuse selon la revendication 12, la N-méthylpyrrolidone étant contenue en une quantité de 0,1 à 10%.

14. Utilisation d'une solution aqueuse selon les revendications 1 à 13, pour l'élimination des résidus post-gravure dans la fabrication de semi-conducteurs.

15. Procédé pour l'élimination des résidus post-gravure de substrats semi-conducteurs après la gravure à sec, dans lequel le substrat de semi-conducteur est soumis à une étape de gravure et ensuite traité par une solution selon l'une quelconque des revendications 1 à 13.
